# EUROPEAN PATENT APPLICATION

(11) **EP 3 865 234 A1**
(43) Date of publication of application: **18.08.2021**
(21) Application number: 19871428.9
(22) Date of filing: 10.07.2019
(51) Int. Cl.: B23B 27/14, B23C 5/16, C23C 14/06

(54) **CUTTING TOOL AND MANUFACTURING METHOD THEREFOR**

(30) Priority: 10.10.2018 JP 2018191736
(71) Applicant: Sumitomo Electric Hardmetal Corp., Itami-shi, Hyogo 664-0016 (JP)
(72) Inventor: FUKUI, Haruyo, Itami-shi, Hyogo 664-0016 (JP); SETOYAMA, Makoto, Itami-shi, Hyogo 664-0016 (JP); TANAKA, Keizo, Itami-shi, Hyogo 664-0016 (JP)
(74) Representative: Boult Wade Tennant LLP
(86) International application number: PCT/JP2019/027268
(87) International publication number: WO 2020/075355

(57) **Abstract**

A cutting tool includes: a substrate; and a coating film formed on the substrate, wherein the coating film includes a first layer formed on the substrate, and a second layer formed on the first layer, the first layer is composed of a boride including titanium as a component element, and the second layer is composed of a nitride including zirconium as a component element.

## Description

### TECHNICAL FIELD

The present disclosure relates to a cutting tool and a method for manufacturing the cutting tool. The present application claims a priority based on Japanese Patent Application No. 2018-191736 filed on October 10, 2018, the entire content of which is incorporated herein by reference.

### BACKGROUND ART

Technical trends for cutting tools in recent years are as follows: (1) a dry process employing no cutting fluid is required in view of global environmental protection; (2) a cutting speed becomes faster in order to improve process efficiency; (3) various types of workpieces are used; and (4) cutting of a titanium alloy or the like, which is used as a heat-resistant alloy and a weight-saving material, becomes more frequent in technical fields such as a field of aerospace (rockets and engines), a field of chemical plants (electrodes, reaction vessels, and heat exchangers), a field of vehicles and motorcycles (engine components, super electric motors, springs, and mufflers), and a field of medical care (implants). Under such circumstances, a cutting edge temperature (temperature of a cutting edge) of a surface-coated cutting tool in a cutting step tends to be high. When the cutting edge temperature becomes high, the surface-coated cutting tool reacts with a workpiece, with the result that the life of the surface-coated cutting tool tends to become short. Therefore, there has been required a surface-coated cutting tool that can exhibit an excellent tool life even under such a severe cutting condition.

For example, in order to improve wear resistance of a cutting tool in high-speed and high-efficiency cutting, Japanese Patent Laying-Open No. 2003-034859 (Patent Literature 1) discloses a cutting-tool hard coating film composed of (Al_{b},[Cr_{1-α}V_{α}]_{c})(C_{1-d}N_{d}), where 0.5≤b≤0.8, 0.2≤c≤0.5, b+c=1, 0.05≤α≤0.95, and 0.5≤d≤1. Further, Patent Literature 1 also discloses a cutting-tool hard coating film composed of (Mₐ,Al_{b},[Cr_{1-α}V_{α}]_{c})(C_{1-d}N_{d}), where M is at least one selected from a group consisting of Ti, Nb, W, Ta and Mo, where 0.02≤a≤0.3, 0.5≤b≤0.8, 0.05≤c, a+b+c=1, 0.5≤d≤1, and 0≤α≤1.

Moreover, in order to perform a dry process with high processing efficiency, WO 2006/070730 (Patent Literature 2) discloses a surface-coated cutting tool including a coating layer including an alternating layer in which A and B layers are layered alternately, wherein the A layer is composed of a nitride including Al and Cr, and the B layer is composed of a nitride including Ti and Al.

### CITATION LIST

### PATENT LITERATURE

PTL 1: Japanese Patent Laying-Open No. 2003-034859
PTL 2: WO 2006/070730

### SUMMARY OF INVENTION

A cutting tool according to one embodiment of the present disclosure is a cutting tool including: a substrate; and a coating film formed on the substrate, wherein
the coating film includes a first layer formed on the substrate, and a second layer formed on the first layer,
the first layer is composed of a boride including titanium as a component element, and
the second layer is composed of a nitride including zirconium as a component element.

A method for manufacturing a cutting tool according to another embodiment of the present disclosure is a method for manufacturing the above-described cutting tool, the method including:
preparing the substrate;
forming the first layer on the substrate using a physical vapor deposition method; and
forming the second layer on the first layer using the physical vapor deposition method.

### BRIEF DESCRIPTION OF DRAWINGS

Fig. 1 is a schematic enlarged cross sectional view of a cutting tool according to one embodiment of the present disclosure.
Fig. 2 is a schematic enlarged cross sectional view of a cutting tool according to another embodiment of the present disclosure.
Fig. 3 is a schematic enlarged cross sectional view of a cutting tool according to still another embodiment of the present disclosure.
Fig. 4 is a schematic enlarged cross sectional view of a cutting tool according to yet another embodiment of the present disclosure.
Fig. 5 is a schematic cross sectional view of a magnetron sputtering device used in an Example.
Fig. 6 is a schematic plan view of the magnetron sputtering device shown in Fig. 5.

### DETAILED DESCRIPTION

### [Problem to be solved by the Present Disclosure]

Cr is contained in many of heat-resistant alloys that are used for engines of airplanes or the like such as Inconel (registered trademark). When a heat-resistant alloy containing Cr is cut using a cutting tool having a hard coating film containing Cr, Cr in the coating layer and Cr in the workpiece are diffused to each other, with the result that damage of the coating layer may be accelerated.

Moreover, a titanium alloy frequently used in the health care industry, the aircraft industry, and the like is referred to as a "difficult-to-cut material", and has the following features: (1) a cutting temperature becomes high because the titanium alloy has a high strength under a high temperature; and (2) heat is accumulated in the cutting edge because the titanium alloy has a low thermal conductivity, and welding and wear are likely to be progressed because the titanium alloy is chemically active. When cutting such a titanium alloy, the life of the cutting tool may be decreased due to heat generated by the cutting and chatter vibration may occur during the cutting to result in decreased processing precision.

Thus, the present disclosure has an object to provide: a cutting tool that can attain a long life in processing a workpiece including titanium; and a method for manufacturing the cutting tool.

### [Advantageous Effect of the Present Disclosure]

According to the above-described embodiment, there can be provided: a cutting tool that can attain a long life in processing a workpiece including titanium; and a method for manufacturing the cutting tool.

### [Description of Embodiments]

First, embodiments of the present disclosure are listed and described.
(1) A cutting tool according to one embodiment of the present disclosure is a cutting tool including: a substrate; and a coating film formed on the substrate, wherein
   the coating film includes a first layer formed on the substrate, and a second layer formed on the first layer,
   the first layer is composed of a boride including titanium as a component element, and
   the second layer is composed of a nitride including zirconium as a component element.
   With such a configuration, the cutting tool can attain a long life in processing a workpiece including titanium.
(2) The first layer has a thickness of more than or equal to 0.5 µm and less than or equal to 10 µm. Accordingly, the cutting tool can attain a longer life in processing a workpiece including titanium.
(3) The second layer has a thickness of more than or equal to 0.5 µm and less than or equal to 10 µm. Accordingly, the cutting tool can attain a longer life in processing a workpiece including titanium.
(4) The boride includes TiB₂. Accordingly, since heat permeability of the cutting tool as a whole is further improved due to high film hardness and high thermal conductivity, cutting heat can be transferred to the substrate (in the case where the cutting tool is a cutting insert, to a holder that fixes the cutting insert), with the result that wear resistance of the cutting tool during continuous cutting is improved particularly.
(5) The nitride includes ZrN. Accordingly, welding with a workpiece is reduced and wear resistance of the cutting tool during continuous cutting is improved particularly.
(6) The boride further includes silicon as a component element, and
   a ratio of a number of atoms of the silicon is more than 0 and less than or equal to 0.2 when a total number of metal atoms included in the boride is assumed to be 1. Accordingly, the coating film can have a high hardness.
(7) The nitride further includes silicon as a component element, and
   a ratio of a number of atoms of the silicon is more than 0 and less than or equal to 0.2 when a total number of metal atoms included in the nitride is assumed to be 1. Accordingly, the coating film can have a high hardness.
(8) The boride further includes vanadium as a component element, and
   a ratio of a number of atoms of the vanadium is more than 0 and less than or equal to 0.2 when a total number of metal atoms included in the boride is assumed to be 1. When the vanadium is included in the boride, an oxide having a low melting point is generated to improve lubricity, whereby a frictional wear characteristic of the boride is improved.
(9) The nitride further includes vanadium as a component element, and
   a ratio of a number of atoms of the vanadium is more than 0 and less than or equal to 0.2 when a total number of metal atoms included in the nitride is assumed to be 1. Accordingly, the coating film can have a high lubricity on its surface.
(10) The coating film further includes a surface layer formed on the second layer, and
   the surface layer is composed of a carbonitride including zirconium as a component element. Accordingly, welding resistance of the cutting tool can be improved, thereby attaining a longer life.
(11) The coating film further includes an underlying layer formed between the substrate and the first layer, and
   the underlying layer is composed of a metal or compound including, as a component element, at least one element selected from a group consisting of titanium and chromium. Accordingly, the cutting tool is excellent in adhesion.
(12) A method for manufacturing a cutting tool according to one embodiment of the present disclosure is a method for manufacturing the cutting tool recited in any one of (1) to (11), the method including:
   preparing the substrate;
   forming the first layer on the substrate using a physical vapor deposition method; and
   forming the second layer on the first layer using the physical vapor deposition method.

The coating film formed using the physical vapor deposition method can have a high crystallinity, and can have an excellent wear resistance. Therefore, the obtained cutting tool can attain a long life.

### [Details of Embodiments of the Present Disclosure]

The following describes one embodiment (hereinafter, referred to as "the present embodiment") of the present disclosure. However, the present embodiment is not limited thereto. It should be noted that the same reference characters indicate the same or equivalent portions in the figures used for the below description of the embodiment. In the present specification, the expression "A to B" represents a range of lower to upper limits (i.e., more than or equal to A and less than or equal to B). When no unit is indicated for A and a unit is indicated only for B, the unit of A is the same as the unit of B.

Further, in the present specification, when a compound is expressed by a chemical formula in which a composition ratio of component elements is not limited such as "ZrN", it is assumed that the chemical formula includes all the conventionally known composition ratios (element ratios). In this case, it is assumed that the above-described chemical formula includes not only a stoichiometric composition but also a non-stoichiometric composition. For example, the chemical formula "ZrN" includes not only a stoichiometric composition "Zr₁N₁" but also a non-stoichiometric composition such as "Zr₁N_{0.8}". The same also applies to compounds other than "ZrN".

### <<Surface-Coated Cutting Tool>>

A surface-coated cutting tool (hereinafter, simply also referred to as "cutting tool") according to the present embodiment is a cutting tool including: a substrate; and a coating film formed on the substrate, wherein
the coating film includes a first layer formed on the substrate, and a second layer formed on the first layer,
the first layer is composed of a boride including titanium as a component element, and
the second layer is composed of a nitride including zirconium as a component element.

With such a configuration, the above-described cutting tool can attain a long life in processing a workpiece including titanium. Here, the "workpiece including titanium" refers to a workpiece composed of metallic titanium, or a workpiece composed of an alloy including titanium as a component element. Examples of the alloy including titanium include a Ti6AL-4V alloy and the like.

The cutting tool according to the present embodiment has the coating film including: the first layer composed of a boride including titanium as a component element; and the second layer composed of a nitride including zirconium as a component element. Since the first layer has a high thermal conductivity, heat permeability of the cutting tool as a whole is improved, whereby cutting heat generated during cutting can be transferred to the substrate. Accordingly, wear resistance of the cutting tool during continuous cutting is improved particularly, thus resulting in a longer life.

Conventionally, when forming a coating film on a substrate of a cutting tool, layers of the coating film are layered sequentially from a layer having a hardness closest to that of the substrate and a layer having the highest hardness is formed at the surface side of the coating film because the coating film has a higher hardness than that of the substrate.

However, the present inventors had paid attention to high thermal conductivity of a "boride including titanium as a component element", and had first found the following configuration in order to promptly transfer, to the substrate side, cutting heat accumulated in the coating film: the boride is formed on the substrate as a first layer; and a "nitride including zirconium as a component element", which has a hardness lower than that of the boride, is formed on the first layer.

Moreover, the first layer tends to have a high compressive residual stress, a high hardness, and a low toughness. The second layer tends to have a lower stress, a lower hardness and a higher toughness than those of the first layer. Since the characteristic of the first layer and the characteristic of the second layer are thus different, the characteristic that the toughness of the first layer is low is complemented by the second layer having a high toughness, and the characteristic that the compressive residual stress of the second layer is small is complemented by the first layer having a large compressive residual stress. Therefore, it is considered that the toughness, hardness, and compressive residual stress are improved in excellent balance in the coating film as a whole, with the result that the life of the cutting tool becomes long in processing a workpiece including titanium. It should be noted that the cutting tool is a cutting tool suitable to process a workpiece including titanium, but can be used to process other conventionally known materials such as iron, steel, cast iron, and stainless steel.

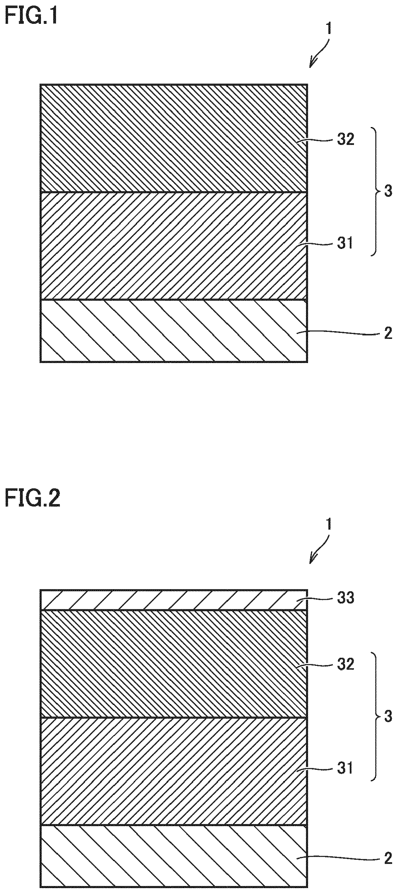

The cutting tool will be described with reference to Fig. 1. Fig. 1 is a schematic enlarged cross sectional view of the cutting tool according to one embodiment of the present disclosure.

As shown in Fig. 1, a cutting tool 1 according to one embodiment of the present disclosure includes a substrate 2 and a coating film 3 formed on substrate 2. Coating film 3 preferably coats an entire surface of substrate 2; however, substrate 2 having a portion not coated with coating film 3 or coating film 3 having a partially different configuration is not deviated from the scope of the present embodiment.

The cutting tool according to the present embodiment can be suitably used as a cutting tool such as a drill, an end mill, an indexable cutting insert for drill, an indexable cutting insert for end mill, an indexable cutting insert for milling, an indexable cutting insert for turning, a metal saw, a gear cutting tool, a reamer, a tap, or the like.

### <Substrate>

For substrate 2 used in cutting tool 1 of the present embodiment, any conventionally known substrate for such a purpose of use can be used. For example, substrate 2 is preferably one selected from a group consisting of: a cemented carbide (for example, a tungsten carbide (WC) based cemented carbide, a cemented carbide including Co in addition to WC, or a cemented carbide having a carbonitride of Ti, Ta, Nb, or the like added therein in addition to WC); a cermet (including TiC, TiN, TiCN, or the like as a main component); a high-speed steel; a ceramic (titanium carbide, silicon carbide, silicon nitride, aluminum nitride, aluminum oxide, or the like); a cubic boron nitride sintered material (cBN sintered material); and a diamond sintered material.

Among these various types of substrates, it is particularly preferable to select the WC-based cemented carbide or the cermet (particularly, the TiCN based cermet). Each of these substrates is excellent particularly in balance between hardness and strength under a high temperature, and therefore can contribute to a long life of a cutting tool when used as a substrate of the cutting tool.

### <Coating Film>

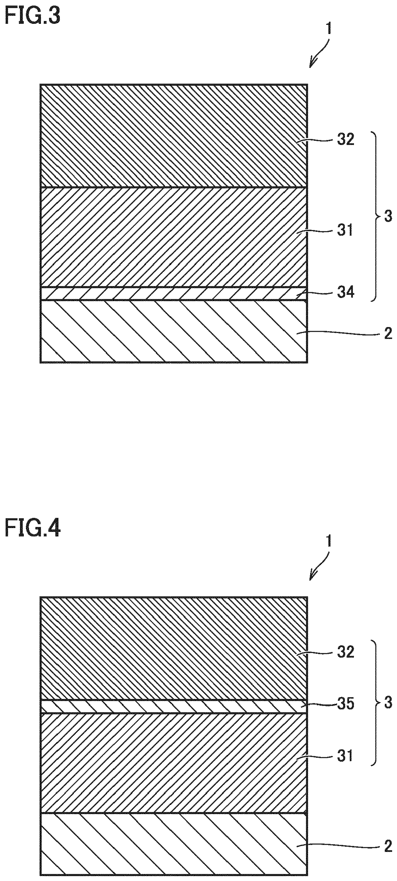

Coating film 3 included in cutting tool 1 of the present embodiment includes: a first layer 31 formed on substrate 2; and a second layer 32 formed on first layer 31 (Fig. 1). Coating film 3 can include other layer(s) in addition to first layer 31 and second layer 32. Examples of the other layer(s) include: a surface layer 33 (Fig. 2) formed on second layer 32; an underlying layer 34 (Fig. 3) formed between substrate 2 and first layer 31; an intermediate layer 35 (Fig. 4) formed between first layer 31 and second layer 32; and the like. Surface layer 33, underlying layer 34, and intermediate layer 35 will be described later.

Coating film 3 has a function to coat substrate 2 so as to improve various characteristics of the cutting tool such as wear resistance and breakage resistance, thus resulting in a long life of the cutting tool.

The coating film preferably has an entire thickness of more than or equal to 1 µm and less than or equal to 15 µm. When the entire thickness of the coating film is less than 1 µm, the thickness of the coating film is too thin, with the result that a desired effect may not be attained. On the other hand, when the entire thickness of the coating film is more than 15 µm, the coating film is likely to be chipped at an early stage of cutting, with the result that the life of the cutting tool tends to be short. The entire thickness of the coating film can be measured by observing a cross section of the coating film using a SEM (scanning electron microscope). Specifically, the "thickness" is represented by an average value of measured thicknesses at three positions in one field of view with an observation magnification being set to 5000x to 10000x for the cross section sample and with an observed area being set to 100 to 500 µm². The same applies to the thickness of each of the below-described layers unless otherwise described particularly.

The absolute value of the compressive residual stress of the coating film is preferably less than or equal to 6 GPa. The compressive residual stress of the coating film is one type of internal stress (inherent strain) existing in the whole of the coating film, and is a residual stress represented by a numerical value (unit: "GPa" in the present embodiment) with a negative sign "-" (minus). Hence, a concept "large compressive residual stress" indicates that the absolute value of the numerical value is large. On the other hand, a concept "small compressive residual stress" indicates that the absolute value of the numerical value is small. That is, the expression "the absolute value of the compressive residual stress is less than or equal to 6 GPa" means that the residual stress of the coating film is more than or equal to -6 GPa and less than 0 GPa.

When the residual stress of the coating film is more than 0 GPa, the residual stress becomes tensile residual stress, with the result that progress of a crack generated from the outermost surface of the coating film tends to be avoided unlikely. On the other hand, when the absolute value of the compressive residual stress is more than 6 GPa, the compressive residual stress is too large, with the result that the coating film is detached particularly from an edge portion of the cutting tool before starting cutting. Accordingly, the life of the cutting tool tends to be short.

The compressive residual stress can be measured using an X-ray residual stress device in accordance with a 2θ-sin²ψ method (see pages 54 to 66 of "X-ray stress measuring method" (Society of Materials Science, Japan, 1981, published by YOKENDO).

The hardness of the coating film is preferably more than or equal to 29 GPa and less than or equal to 60 GPa, and is more preferably more than or equal to 40 GPa and less than or equal to 60 GPa. Accordingly, the coating film has a sufficient hardness. It should be noted that the hardness of the whole of the coating film can be measured by a method employing a nano indenter (for example, Nano Indenter XP provided by MTS). Specifically, the "hardness" is represented by an average value of hardnesses measured at three positions on the surface of the coating film.

### (First Layer)

The first layer is formed on the substrate. Here, the first layer may be formed directly in contact with the surface of the substrate, or may be formed on the substrate with the below-described underlying layer being interposed therebetween. The first layer is composed of a boride including Ti (titanium) as a component element. Thus, the first layer has a high film hardness and a high thermal conductivity. Accordingly, heat permeability of the cutting tool as a whole can be improved, whereby cutting heat can be transferred to the substrate. Particularly, in processing of a difficult-to-cut material during which the cutting edge temperature becomes high, the wear resistance of the cutting tool is improved, whereby a long life can be attained.

Examples of the above-described boride include TiB₂, TiB, TiSiB₂, TiVB₂ and the like. The boride preferably includes TiB₂. One type of boride may be solely used or a plurality of types of borides may be used in combination.

The composition of the first layer and a ratio of the number of atoms (Ti and B as well as Si and V, which are described later) to the total number of metal atoms in the first layer can be measured using an X-ray photoelectron spectroscopy device (XPS). Specifically, the composition and chemical bonding state of elements included in a sample surface are analyzed by irradiating the sample surface with X rays and measuring kinetic energy of photoelectrons emitted from the sample surface. Likewise, the X-ray photoelectron spectroscopy device (XPS) can be used to measure: the composition of each of the layers including the below-described second layer, underlying layer, surface layer, and intermediate layer; and the ratio of the number of atoms (Ti, Cr, Zr, Si, and V) to the total number of metal atoms in each layer.

In the present specification, the term "metal atom" refers to an atom of an element other than hydrogen, helium, neon, argon, krypton, xenon, radon, fluorine, chlorine, bromine, iodine, astatine, oxygen, sulfur, selenium, tellurium, nitrogen, phosphorus, arsenic, antimony, carbon and boron.

The boride preferably has a hexagonal crystal structure. When the boride has a hexagonal crystal structure and is oriented in (001), the c axis of each crystal is perpendicular to the main surface of the substrate, with the result that strength tends to become high and wear resistance tends to be improved. The crystal structure in the first layer can be analyzed using an X-ray diffractometer well-known in the field.

The boride may include Si (silicon) as a component element. That is, the boride further includes silicon as a component element, and a ratio of the number of atoms of the silicon is preferably more than 0 and less than or equal to 0.2 when a total number of metal atoms included in the boride is assumed to be 1. Examples of the boride include Ti_{1-y}Si_{y}B₂, where y is more than 0 and less than or equal to 0.2. When the boride further includes silicon as a component element, the structure of the first layer becomes fine to further increase the hardness to result in high hardness of the whole of the coating film and improved oxidation resistance although a mechanism thereof is unknown.

When the ratio of the number of atoms of the silicon is more than 0.2, the first layer becomes brittle, with the result that wear tends to be promoted. Moreover, when a hot isostatic process is employed to produce an alloy target to serve as a metal source material of the above-described boride, the alloy target is cracked during calcination, with the result that it tends to become difficult to achieve a material strength usable for formation of the first layer.

In order to increase the hardness of the first layer and improve the strength of the alloy target, the ratio of the number of atoms of the silicon is more preferably more than or equal to 0.01 and less than or equal to 0.15, and is further preferably more than or equal to 0.05 and less than or equal to 0.15 when the total number of the metal atoms included in the boride is assumed to be 1.

The boride may include V (vanadium) as a component element. That is, the boride further includes vanadium as a component element, and a ratio of the number of atoms of the vanadium is preferably more than 0 and less than or equal to 0.2 when a total number of metal atoms included in the boride is assumed to be 1. Examples of the boride includes Ti_{1-z}V_{z}B₂, where z is more than 0 and less than or equal to 0.2. In this case, even when the surface of the first layer is oxidized in a high temperature environment during cutting, a vanadium oxide, which has a low melting point, serves as a lubricant during the cutting, whereby welding of a workpiece can be suppressed.

When the ratio of the number of atoms of the vanadium is more than 0.2, the hardness of the first layer tends to be decreased. In order to increase the hardness of the first layer, the ratio of the number of atoms of the vanadium is more preferably more than 0 and less than or equal to 0.15, and is further preferably more than or equal to 0.05 and less than or equal to 0.15 when the total number of metal atoms included in the boride is assumed to be 1.

The first layer may include an inevitable impurity other than Ti, B, Si, and V. That is, the expression "the first layer is composed of a boride including titanium as a component element" represents a concept including not only a case where the first layer is composed only of the boride including titanium as a component element but also a case where the first layer includes the boride including titanium as a component element and an inevitable impurity mixed therein as long as the effect of the present disclosure is exhibited. Examples of the inevitable impurity include oxygen, carbon, and the like. The content ratio of the whole of the inevitable impurity in the first layer is preferably more than 0 atom% and less than 1 atom%. It should be noted that the term "atom%" in the present specification indicates a ratio (%) of the number of atoms to the total number of atoms included in the first layer. The ratio (%) of the number of atoms to the total number of atoms included in the first layer can be measured using the above-described XPS analysis.

The thickness of the first layer is preferably more than or equal to 0.5 µm and less than or equal to 10 µm, and is more preferably more than or equal to 0.5 µm and less than or equal to 4 µm. The thickness of the first layer can be measured by observing a cross section of the coating film using a SEM (scanning electron microscope).

### (Second Layer)

The second layer is formed on the first layer. Here, the second layer may be formed directly in contact with the surface of the first layer, or may be formed on the first layer with the below-described intermediate layer being interposed therebetween. The second layer is composed of a nitride including Zr (zirconium) as a component element. Since zirconium is included as a component element, the second layer is excellent in balance among wear resistance, oxidation resistance, and toughness. Moreover, when Cr (chromium) and Ti are not included in the second layer, damage in the coating film is not progressed due to diffusion of the elements of the workpiece. Therefore, the cutting tool including the second layer can attain a long life.

Examples of the nitride include ZrN, ZrSiN, ZrVN, and the like. The nitride preferably includes ZrN. One type of nitride may be solely used or a plurality of types of nitrides may be used in combination.

The nitride preferably has a cubic crystal structure. When the nitride has a cubic crystal structure and is oriented in (111), which is a dense crystal plane, strength becomes high and wear resistance is improved. It should be noted that the crystal structure in the second layer can be analyzed using an X-ray diffractometer well-known in the field.

The nitride may include Si (silicon) as a component element. That is, the nitride further includes silicon as a component element, and a ratio of the number of atoms of the silicon is preferably more than 0 and less than or equal to 0.2 when a total number of metal atoms included in the nitride is assumed to be 1. Examples of the nitride include Zr₁₋ᵥSiᵥN, where v is more than 0 and less than or equal to 0.2. When the nitride further includes silicon as a component element, the structure of the second layer becomes fine to further increase the hardness to result in high hardness of the whole of the coating film and improved oxidation resistance of the whole of the coating film although a mechanism thereof is unknown.

When the ratio of the number of atoms of the silicon is more than 0.2, the second layer becomes brittle, with the result that wear tends to be promoted. Moreover, when a hot isostatic process is employed to produce an alloy target to serve as a metal source material of the above-described nitride, the alloy target is cracked during calcination, with the result that it tends to become difficult to achieve a material strength usable for formation of the second layer.

In order to increase the hardness of the second layer and improve the strength of the alloy target, the ratio of the number of atoms of the silicon is more preferably more than or equal to 0.01 and less than or equal to 0.15, and is further preferably more than or equal to 0.05 and less than or equal to 0.15 when the total number of the metal atoms included in the nitride is assumed to be 1.

The nitride may include V (vanadium) as a component element. That is, the nitride further includes vanadium as a component element, and a ratio of atoms of the vanadium is preferably more than 0 and less than or equal to 0.2 when a total number of metal atoms included in the nitride is assumed to be 1. Examples of the nitride include Zr_{1-w}V_{w}N, where w is more than 0 and less than or equal to 0.2. In this case, even when the surface of the second layer is oxidized in a high temperature environment during cutting, a vanadium oxide, which has a low melting point, serves as a lubricant during the cutting, whereby welding of a workpiece can be suppressed.

When the ratio of the number of atoms of the vanadium is more than 0.2, the hardness of the second layer tends to be decreased. In order to suppress welding of the workpiece and increase the hardness of the second layer, the ratio of the number of atoms of the vanadium is more preferably more than 0 and less than or equal to 0.15, and is further preferably more than or equal to 0.05 and less than or equal to 0.15 when the total number of metal atoms included in the nitride is assumed to be 1.

The second layer may include an inevitable impurity other than Zr, Si, V, and N. That is, the expression "the second layer is composed of a nitride including zirconium as a component element" represents a concept including not only a case where the second layer is composed only of the nitride including zirconium as a component element but also a case where the second layer includes the nitride including zirconium as a component element and an inevitable impurity mixed therein as long as the effect of the present disclosure is exhibited. Examples of the inevitable impurity include oxygen, carbon, and the like. The content ratio of the whole of the inevitable impurity in the second layer is preferably more than 0 atom% and less than 1 atom%. The ratio (%) of the number of atoms to the total number of the atoms included in the second layer can be measured using the above-described XPS analysis.

The thickness of the second layer is preferably more than or equal to 0.5 µm and less than or equal to 10 µm, and is more preferably more than or equal to 0.5 µm and less than or equal to 4 µm. The thickness of the second layer can be measured by observing a cross section of the coating film using a SEM (scanning electron microscope).

Moreover, the total thickness of the first layer and the second layer is preferably more than or equal to 1 µm and less than or equal to 20 µm, is more preferably more than or equal to 1 µm and less than or equal to 15 µm, and is further preferably more than or equal to 2 µm and less than or equal to 7 µm. When the thickness is less than 1 µm, wear resistance tends to be unable to be sufficiently exhibited in continuous processing. When the thickness is more than 20 µm, chipping resistance tends to be unstable in intermittent cutting.

### (Other Layer(s))

Coating film 3 included in cutting tool 1 of the present embodiment can include other layer(s) in addition to first layer 31 and second layer 32. Examples of the other layer(s) include: surface layer 33 (Fig. 2) formed on second layer 32; underlying layer 34 (Fig. 3) formed between substrate 2 and first layer 31; intermediate layer 35 (Fig. 4) formed between first layer 31 and second layer 32; and the like.

### (Surface Layer)

Surface layer 33 according to the present embodiment is formed on second layer 32 (Fig. 2). Surface layer 33 may be constituted of a single layer or may be constituted of a plurality of layers. Surface layer 33 is preferably composed of a carbonitride including zirconium as a component element. Examples of the carbonitride include ZrCN, ZrSiCN, ZrVCN, and the like. One type of carbonitride may be solely used or a plurality of types of carbonitrides may be used in combination.

Generally, the coefficient of friction of a carbonitride with respect to a workpiece tends to be lower than the coefficient of friction of a nitride with respect to the workpiece. It is considered that carbon atoms contributes to such a decrease of the coefficient of friction. When the coating film includes the surface layer, the coefficient of friction of the coating film with respect to the workpiece is decreased, with the result that the cutting tool has a long life.

By adjusting a composition ratio of N and C in the surface layer, a predetermined color can be provided. Accordingly, design and distinctiveness can be provided to the appearance of the cutting tool. This is industrially useful.

The carbonitride preferably further includes silicon as a component element. A ratio of the number of atoms of the silicon is preferably more than 0 and less than or equal to 0.2 and is more preferably more than or equal to 0.05 and less than or equal to 0.15 when the total number of metal atoms included in the carbonitride is assumed to be 1. Accordingly, the hardness of the surface layer becomes high and oxidation resistance of the surface layer is improved.

The carbonitride preferably further includes vanadium as a component element. A ratio of the number of atoms of the vanadium is preferably more than 0 and less than or equal to 0.2, and is more preferably more than 0 and less than or equal to 0.15 when the total number of metal atoms included in the carbonitride is assumed to be 1. Accordingly, welding resistance of the surface layer is improved.

The carbonitride preferably further includes B (boron) as a component element. A ratio of the number of atoms of the boron is preferably more than 0 and less than or equal to 0.5, and is more preferably more than 0 and less than or equal to 0.2 when the total number of nonmetallic atoms (i.e., C, N, and B) included in the carbonitride is assumed to be 1. Accordingly, the hardness of the coating film is improved.

The thickness of the surface layer is preferably more than or equal to 0.1 µm. When the thickness of the surface layer is less than 0.1 µm, the effect of providing lubrication by the surface layer tends to be obtained unlikely. On the other hand, the upper limit value of the thickness of the surface layer is not particularly limited; however, even when the thickness of the surface layer becomes more than 2 µm, the effect of providing lubrication tends to be unchanged any more. Therefore, in consideration of cost, the thickness of the surface layer is preferably less than or equal to 2 µm. The thickness of the surface layer can be measured by observing a cross section of the coating film using a SEM (scanning electron microscope).

### (Underlying Layer)

Underlying layer 34 according to the present embodiment is formed between substrate 2 and first layer 31 (Fig. 3). Underlying layer 34 may be constituted of a single layer or a plurality of layers. Underlying layer 34 is preferably composed of a metal or compound including, as a component element, at least one element selected from a group consisting of Ti (titanium) and Cr (chromium). By providing the underlying layer, adhesion force between substrate 1 and first layer 31 tends to be improved. Examples of the metal includes metallic titanium, metallic chromium, an alloy including titanium and chromium as component elements, and the like. Examples of the compound include CrN, TiN, and the like.

The thickness of the underlying layer is preferably more than or equal to 2 nm and less than or equal to 0.5 µm, and is more preferably more than or equal to 2 nm and less than or equal to 0.1 µm. The thickness of the underlying layer can be measured by observing a cross section of the coating film using a SEM (scanning electron microscope) or a TEM (transmission electron microscope).

### <<Method for Manufacturing Surface-Coated Cutting Tool>>

A method for manufacturing a cutting tool according to one embodiment of the present disclosure is a method for manufacturing the above-described cutting tool, the method including:
a step (hereinafter, also referred to as "first step") of preparing the substrate; and
a step (hereinafter, also referred to as "second step") of forming the first layer on the substrate using a physical vapor deposition method; and
a step (hereinafter, also referred to as "third step") of forming the second layer on the first layer using the physical vapor deposition method.

In the method for manufacturing the cutting tool, a coating film having a wear resistance is intended to be formed on the surface of the substrate, so that it is desirable to form a layer composed of a compound having a high crystallinity. In order to develop such a coating film, the present inventors studied various film formation techniques. As a result, it was appropriate to use the physical vapor deposition method as means for developing such a coating film. The physical vapor deposition method is a deposition method in which a source material (also referred to as "evaporation source" or "target") is vaporized using a physical action, and the vaporized source material is adhered onto the substrate. Particularly, the physical vapor deposition method used in the present embodiment is preferably at least one selected from a group consisting of a cathode arc ion plating method, a balanced magnetron sputtering method, and an unbalanced magnetron sputtering method.

When the cathode arc ion plating method is used, a metal ion bombardment cleaning process can be performed onto the surface of the substrate before forming the coating film. Hence, a cleaning time can be reduced. In the cathode arc ion plating method, after disposing the substrate in a device and disposing the target as a cathode, high current is applied to this target to cause arc discharge. Accordingly, the target is evaporated to ionize the atoms thereof to deposit them on the substrate fed with negative bias voltage, thereby forming the coating film.

Further, for example, in the balanced magnetron sputtering method, the substrate is disposed in the device, the target is disposed on a magnetron electrode including a magnet for forming a balanced magnetic field, and high-frequency power is applied between the magnetron electrode and the substrate, thereby generating gas plasma. Ions of gas resulting from the generation of this gas plasma are collided with the target, and atoms ejected from the target are ionized to be deposited on the substrate, thereby forming the coating film.

In the unbalanced magnetron sputtering method, the magnetic field generated by the magnetron electrode in the balanced magnetron sputtering method is made unbalanced, thereby forming the coating film.

### <First Step: Step of Preparing Substrate>

In the first step, the substrate is prepared. For example, a cemented carbide substrate is prepared as the substrate. For the cemented carbide substrate, a commercially available cemented carbide substrate may be used or a cemented carbide substrate may be produced using a general powder metallurgy method. In the production using the general powder metallurgy method, for example, WC powder, Co powder, and the like are mixed using a ball mill or the like to obtain a powder mixture. This powder mixture is dried and then is formed into a predetermined shape, thereby obtaining a shaped body. Further, by sintering the shaped body, a WC-Co based cemented carbide (sintered material) is obtained. Next, this sintered material is subjected to a predetermined cutting edge process such as honing, thereby producing a substrate composed of the WC-Co based cemented carbide. In the first step, any conventionally known substrate other than the above-described substrate can be prepared.

### (Step of Cleaning Substrate)

Before the second step described below, a step of cleaning the substrate may be performed. For example, an ion bombardment process may be performed onto the surface of the substrate before forming the first layer using the magnetron sputtering method in the second step. Accordingly, for example, when the cemented carbide substrate is used as the substrate, a soft binder phase can be removed from the surface of the substrate. Then, the first layer or the underlying layer is formed on the substrate, thereby increasing a ratio of the hard particles in a portion of contact between the first layer or the underlying layer and the substrate. In this case, 80% or more of an area of the substrate in contact with the first layer or the underlying layer is more preferably WC.

### (Step of Forming Underlying Layer)

Further, as a result of the ion bombardment process, the underlying layer can be formed. Specifically, in the ion bombardment process, a target including chromium, titanium, or a combination thereof is used, thereby attaching these elements on the surface of the substrate as the underlying layer while cleaning the surface of the substrate. Then, the step of forming the first layer on the surface having these elements attached thereon, i.e., the second step described below, is performed, thereby forming the underlying layer excellent in adhesion force together with the first layer. A more preferable example of the element used for the ion bombardment process and included in the underlying layer is chromium. Since chromium is an element that can be sublimated, a smaller amount of melted particles (droplets) are generated during the ion bombardment process, thereby preventing surface roughness of the substrate.

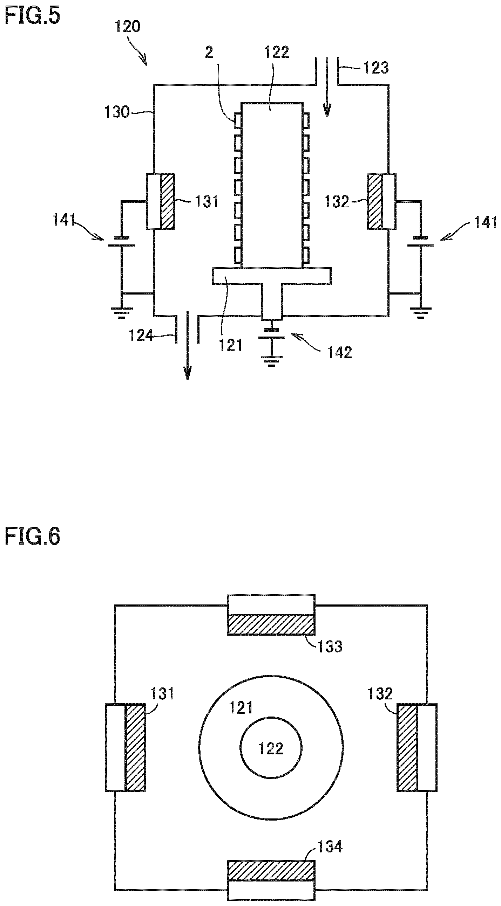

For example, the first step and the subsequent step of cleaning the substrate can be performed as follows. First, an insert having an appropriate shape is prepared as substrate 2 (first step). Then, substrate 2 is attached in a chamber 130 of a film formation device 120. For example, with reference to film formation device 120 shown in Fig. 5, substrate 2 is attached to an outer surface of a substrate holder 122 on a rotation table 121 rotatably disposed at the center in chamber 130. A bias power supply 142 is attached to substrate holder 122.

Next, as shown in Fig. 6, at predetermined positions in chamber 130, alloy targets, each of which is a metal source material of the coating film, are placed on a corresponding first layer formation evaporation source 131, a corresponding second layer formation evaporation source 132, a corresponding ion bombardment evaporation source 133, and a corresponding surface layer formation evaporation source 134. Pulse power supplies 141 are attached to first layer formation evaporation source 131 and second layer formation evaporation source 132, and pulse power supplies (not shown) are also attached to ion bombardment evaporation source 133 and surface layer formation evaporation source 134.

Chamber 130 is provided with: a gas inlet 123 for introducing atmospheric gas; and a gas outlet 124 for discharging atmospheric gas from chamber 130. From this gas outlet 124, the atmospheric gas in chamber 130 can be suctioned using a vacuum pump.

First, a pressure in chamber 130 is reduced using the vacuum pump to 1.0×10⁻⁵ to 1.0×10⁻³ Pa, and the surface of substrate 2 is heated to a temperature of 400 to 700°C using a heater (not shown) disposed in the device while rotating substrate 2 of substrate holder 122 by rotating rotation table 121.

Next, argon gas is introduced as atmospheric gas (sputtering gas) from gas inlet 123, the pressure in chamber 130 is maintained at 1.0 to 4.0 Pa, voltage of bias power supply 142 is gradually increased to be -1000 to -400 V, and the surface of substrate 2 is cleaned for 15 to 90 minutes (ion bombardment process with argon ions). Accordingly, when substrate 2 is a cemented carbide substrate, a binder phase can be removed from the surface.

By applying a power of 5.5 to 7.5 kW to ion bombardment evaporation source 133 using the pulse power supply and performing the ion bombardment process to the surface of substrate 2 for 15 to 90 minutes, the surface of substrate 2 is further cleaned and a predetermined metallic element is adhered to the surface thereof (the step of forming the underlying layer).

### <Second Step: Step of Forming First Layer>

In the second step, the first layer is formed on the substrate. In order to achieve this, various types of methods are used in accordance with a composition of the first layer to be formed. Examples of the methods include: a method employing an alloy target having different sizes of particles such as titanium, boron, silicon, and vanadium; a method employing a plurality of targets having different compositions; a method in which pulse voltage is employed for the bias voltage to be applied during film formation; a method in which a gas flow rate is changed during film formation; a method in which the rotation speed of the substrate holder that holds the substrate is adjusted in the film formation device; or the like. The first layer can also be formed in combination with these methods.

For example, the second step can be performed as follows. Specifically, continuously after cleaning substrate 2, Ar is introduced as an atmospheric gas while rotating substrate 2 at the center of chamber 130. Further, a power of 5.5 to 7.5 kW is supplied to first layer formation evaporation source 131 using pulse power supply 141 while maintaining the temperature of substrate 2 at 400 to 700°C, maintaining the gas pressure at 0.3 to 0.5 Pa, and maintaining the voltage of bias power supply 142 to fall within a range of -30 to -100 V. Accordingly, metal ions and boron ions are generated from evaporation source 131. When a predetermined time has passed, the supply of power from pulse power supply 141 is stopped and the first layer is formed on the surface of substrate 2. Further, by adjusting a film formation time, the thickness of the first layer is adjusted to fall within a predetermined range.

### <Third Step: Step of Forming Second Layer>

In the third step, the second layer is formed on the first layer. In order to achieve this, as with the second step, various types of methods are used in accordance with a composition of the second layer to be formed. Examples of the methods include: a method employing an alloy target having different sizes of particles such as zirconium, silicon, and vanadium; a method employing a plurality of targets having different compositions; a method in which pulse voltage is employed for the bias voltage to be applied during film formation; a method in which a gas flow rate is changed; a method in which the rotation speed of the substrate holder that holds the substrate is adjusted in the film formation device; or the like. The second layer can also be formed in combination with these methods.

For example, the third step can be performed as follows. Specifically, continuously after the step of forming the first layer, argon gas is introduced as a sputtering gas and nitrogen gas is introduced as a reactive gas while rotating, at the center in chamber 130, substrate 2 having the first layer formed thereon. Further, a power of 5.5 to 7.5 kW is supplied from pulse power supply 141 to second layer formation evaporation source 132 while maintaining the temperature of substrate 2 at 400 to 700°C, maintaining the reactive gas pressure at 0.3 to 1 Pa and maintaining the voltage of bias power supply 142 to fall within the range of -30 to -100 V. Accordingly, metal ions are generated from evaporation source 132. Then, when a predetermined time has passed, the supply of power from pulse power supply 141 is stopped, and the second layer is formed on the first layer. Further, by adjusting the film formation time, the thickness of the second layer is adjusted to fall within a predetermined range.

### (Step of Forming Surface Layer)

After the third step, a step of forming the surface layer can be performed. For example, the step of forming the surface layer is performed as follows. Specifically, continuously after the step of forming the second layer, argon gas is introduced as a sputtering gas and nitrogen gas is introduced as a reactive gas while rotating, at the center in chamber 130, substrate 2 having the second layer formed thereon. Further, a power of 5.5 to 7.5 kW is supplied to surface layer formation evaporation source 134 using the pulse power supply while maintaining the temperature of substrate 2 at 400 to 700°C, maintaining the reactive gas pressure at 0.3 to 1 Pa, and maintaining the voltage of bias power supply 142 to fall within the range of -30 to -100 V. Accordingly, metal ions are generated from evaporation source 134. When a predetermined time has passed, the supply of power from pulse power supply 141 is stopped and the surface layer is formed on the second layer. It should be noted that depending on the composition of the surface layer, second layer formation evaporation source 132 may be used to form the surface layer instead of using surface layer formation evaporation source 134.

### (Other Step)

After forming the first layer and the second layer, compressive residual stress may be provided to the coating film. This is because toughness is improved. Compressive residual stress can be provided by a blasting method, a brushing method, a barrel method, an ion implantation method, or the like, for example.

The above description includes features described below.
(Clause 1) A surface-coated cutting tool comprising: a substrate; and a coating film formed on the substrate, wherein
   the coating film includes a first layer formed on the substrate, and a second layer formed on the first layer,
   the first layer is composed of a boride including Ti as a component element, and
   the second layer is composed of a nitride including Zr as a component element.
(Clause 2) The surface-coated cutting tool according to clause 1, wherein the first layer has a thickness of more than or equal to 0.5 µm and less than or equal to 10 µm.
(Clause 3) The surface-coated cutting tool according to clause 1 or clause 2, wherein the second layer has a thickness of more than or equal to 0.5 µm and less than or equal to 10 µm.
(Clause 4) The surface-coated cutting tool according to any one of clause 1 to clause 3, wherein the boride includes TiB₂.
(Clause 5) The surface-coated cutting tool according to any one of clause 1 to clause 4, wherein the nitride includes ZrN.
(Clause 6) The surface-coated cutting tool according to any one of clause 1 to clause 5, wherein
   the boride further includes Si as a component element, and
   a ratio of a number of atoms of the Si is more than 0 and less than or equal to 0.2 when a total number of metal atoms included in the boride is assumed to be 1.
(Clause 7) The surface-coated cutting tool according to any one of clause 1 to clause 6, wherein
   the nitride further includes Si as a component element, and
   a ratio of a number of atoms of the Si is more than 0 and less than or equal to 0.2 when a total number of metal atoms included in the nitride is assumed to be 1.
(Clause 8) The surface-coated cutting tool according to any one of clause 1 to clause 7, wherein
   the boride further includes V as a component element, and
   a ratio of a number of atoms of the V is more than 0 and less than or equal to 0.2 when a total number of metal atoms included in the boride is assumed to be 1.
(Clause 9) The surface-coated cutting tool according to any one of clause 1 to clause 8, wherein
   the nitride further includes V as a component element, and
   a ratio of a number of atoms of the V is more than 0 and less than or equal to 0.2 when a total number of metal atoms included in the nitride is assumed to be 1.
(Clause 10) The surface-coated cutting tool according to any one of clause 1 to clause 9, wherein
   the coating film further includes a surface layer formed on the second layer, and
   the surface layer is composed of a carbonitride including Zr as a component element.
(Clause 11) The surface-coated cutting tool according to any one of clause 1 to clause 10, wherein
   the coating film further includes an underlying layer formed between the substrate and the first layer, and
   the underlying layer is composed of a metal or compound including, as a component element, at least one element selected from a group consisting of Ti and Cr.
(Clause 12) A method for manufacturing the surface-coated cutting tool recited in any one of clause 1 to clause 11, the method comprising:
   preparing the substrate; and
   forming the first layer on the substrate using a physical vapor deposition method; and
   forming the second layer on the first layer using the physical vapor deposition method.

### Examples

While the present invention will be described in detail with reference to Examples, the present invention is not limited thereto. Here, the thickness of each of the below-described coating film, first layer, second layer, and surface layer is a value calculated by the following method. Specifically, the value is calculated by using a SEM (scanning electron microscope) to observe, in the above-described procedure, a cross section obtained by cutting each of produced cutting tools, and averaging measured thicknesses in the cross section thereof.

### <Production of Cutting Tool>

Fig. 5 is a schematic cross sectional view of a film formation device (magnetron sputtering device) used in the present example. Fig. 6 is a schematic plan view of the film formation device used in the present example.

### (First Step: Step of Preparing Substrate)

In the present example, each of an insert composed of a cemented carbide with a grade of JIS P30 and having a shape of CNMG120408 in JIS, an insert of SEMT13T3AGSN provided by Sumitomo Electric Industries HardMetal, and a radius end mill (φ12 mm) was prepared as substrate 2 (the step of preparing the substrate).

As shown in Fig. 5, substrate 2 was attached to the outer surface of substrate holder 122 on rotation table 121 rotatably disposed at the center in chamber 130 of film formation device 120.

As shown in Fig. 6, first layer formation evaporation source (alloy evaporation source composed of a metallic source material having a composition to constitute the first layer) 131, second layer formation evaporation source (alloy evaporation source composed of a metallic source material having a composition to constitute the second layer) 132, and surface layer formation evaporation source (alloy evaporation source composed of a metallic source material having a composition to constitute the surface layer) 134 are attached to chamber 130 to serve as alloy targets as metallic source materials for the coating film.

As shown in Fig. 5, pulse power supplies 141 were attached to first layer formation evaporation source 131 and second layer formation evaporation source 132. Further, the pulse power supplies (not shown) were attached also to ion bombardment evaporation source 133 and surface layer formation evaporation source 134.

A bias power supply 142 was attached to substrate holder 122. Since gas inlet 123 for introducing atmospheric gas and gas outlet 124 for discharging the atmospheric gas from chamber 130 are provided in chamber 130, the atmospheric gas in chamber 130 can be suctioned and discharged from gas outlet 124 using a vacuum pump.

First, in film formation device 120 shown in Fig. 5 and Fig. 6, the pressure in chamber 130 was reduced using the vacuum pump and rotation table 121 was rotated, thereby rotating substrate 2 of substrate holder 122. Then, a heater (not shown) disposed in device 120 was used to heat the surface of substrate 2 at a temperature of 600°C and chamber 130 was vacuumed until the pressure in chamber 130 became 1.0×10⁻⁴ Pa.

### (Step of Cleaning Substrate)

Next, argon gas was introduced as a sputtering gas from gas inlet 123, the pressure in chamber 130 was held at 3.0 Pa, the voltage of bias power supply 142 was gradually increased to be -1000 V, the surface of substrate 2 was cleaned (for 15 minutes), and a process (ion bombardment process with argon ions) was performed to remove a binder phase from the surface of substrate 2. Then, the argon gas was exhausted from the inside of chamber 130 (the step of cleaning the substrate).

### (Second Step: Step of Forming First Layer)

In each of Examples 1 to 10 and Comparative Example 2, continuously after the cleaning of substrate 2, Ar (argon) was introduced as an atmospheric gas while rotating substrate 2 at the center in chamber 130. Further, while maintaining the temperature of substrate 2 at 600°C, maintaining the gas pressure at 0.5 Pa, and maintaining the voltage of bias power supply 142 at a certain value falling within a range of -50 V to - 100 V, a power of 6 kW was supplied to first layer formation evaporation source 131. Accordingly, metal ions and boron ions were generated from evaporation source 131. When a predetermined time had passed, the supply of power was stopped and the first layer having a composition shown in Table 1 was formed on substrate 2. On this occasion, the first layer was produced while adjusting the time of the supply of power, so as to have a thickness shown in Table 1.

In each of Comparative Examples 1 and 3 to 5, the first layer was produced in the same manner as described above except that nitrogen was introduced as a reactive gas in addition to Ar serving as an atmospheric gas so as to form the first layer composed of a nitride.

In each of Comparative Examples 1 and 5, a ZrN layer (layer composed of a compound represented by ZrN; the same applies to the description below) was produced as a layer corresponding to the first layer. In Comparative Examples 3 and 4, an AlTiN layer and an AlCrN layer having compositions shown in Table 1 were produced as layers corresponding to the first layer, respectively. In each of Comparative Example 1 to 4, no second layer was formed as described below. In this way, the second step was performed.

**[Table 1]**

| | First Layer | | | | Second Layer | | | |
|---|---|---|---|---|---|---|---|---|
| | Composition | Crystal Structure | Orientation | Thickness (µm) | Composition | Crystal Structure | Orientation | Thickness (µm) |
| Example 1 | TiB₂ | Hexagonal | (001) | 1.3 | ZrN | Cubic | (111) | 1.2 |
| Example 2 | TiB₂ | Hexagonal | (001) | 1 | ZrN | Cubic | (111) | 1 |
| Example 3 | Ti_{0.95}Si_{0.05}B₂ | Hexagonal | (001) | 1 | ZrN | Cubic | (111) | 1 |
| Example 4 | Ti_{0.95}V_{0.05}B₂ | Hexagonal | (001) | 1 | ZrN | Cubic | (111) | 1 |
| Example 5 | TiB₂ | Hexagonal | (001) | 1 | Zr_{0.95}Si_{0.05}N | Cubic | (111) | 1 |
| Example 6 | TiB₂ | Hexagonal | (001) | 1 | Zr_{0.95}V_{0.05}N | Cubic | (111) | 1 |
| Example 7 | TiB₂ | Hexagonal | (001) | 2 | ZrN | Cubic | (111) | 2 |
| Example 8 | TiB₂ | Hexagonal | (001) | 6 | ZrN | Cubic | (111) | 6 |
| Example 9 | TiB₂ | Hexagonal | (001) | 0.3 | ZrN | Cubic | (111) | 0.3 |
| Example 10 | TiB₂ | Hexagonal | (001) | 0.1 | ZrN | Cubic | (111) | 0.1 |
| Comparative Example 1 | ZrN | Cubic | (111) | 2.5 | - | - | - | - |
| Comparative Example 2 | TiB₂ | Hexagonal | (001) | 2.5 | - | - | - | - |
| Comparative Example 3 | Al_{0.6}Ti_{0.4}N | Cubic | (111) | 2.5 | - | - | - | - |
| Comparative Example 4 | Al_{0.7}Cr_{0.3}N | Cubic | (111) | 2.5 | - | - | - | - |
| Comparative Example 5 | ZrN | Cubic | (111) | 1.2 | TiB₂ | Hexagonal | (001) | 1.3 |

### (Third Step: Step of Forming Second Layer)

Next, in each of Examples 1 to 10, by maintaining the temperature of substrate 2, the gas pressure, and the bias voltage at those described above and supplying a power of 6 kW to second layer formation evaporation source 132, metal ions were generated from evaporation source 132. On this occasion, nitrogen was used as a reactive gas. When a predetermined time had passed, the supply of power was stopped and the second layer having a composition shown in Table 1 was formed on the first layer. On this occasion, the second layer was produced while adjusting the time of the supply of power, so as to have a thickness shown in Table 1.

In each of Comparative Examples 1 to 4, no second layer was formed. In Comparative Example 5, a TiB₂ layer was formed as the second layer.

### (Step of Forming Surface Layer)

Here, in each of Examples 2 to 4 and 7 to 9, continuously after the step of forming the second layer, the surface layer having composition and thickness shown in Table 2 was formed. Specifically, the surface layer was formed by introducing Ar as an atmospheric gas and both nitrogen and methane gas as reactive gases while rotating, at the center of chamber 130, substrate 2 having the second layer formed thereon. Further, while maintaining the temperature of substrate 2 at 400°C, maintaining the reactive gas pressure at 0.4 Pa and maintaining the voltage of bias power supply 142 at -150 V, a power of 6 kW was supplied to surface layer formation evaporation source 134. Accordingly, metal ions were generated from evaporation source 134. When a predetermined time had passed, the supply of power was stopped and the surface layer was formed on the second layer.

**[Table 2]**

| | Surface Layer | | Whole of Coating Film | | |
|---|---|---|---|---|---|
| | Composition | Thickness (µm) | Hardness (GPa) | Compression Residual Stress (GPa) | Thickness (µm) |
| Example 1 | - | - | 46 | 2.1 | 2.5 |
| Example 2 | ZrCN | 0.5 | 47 | 2.0 | 2.5 |
| Example 3 | ZrCN | 0.5 | 53 | 2.2 | 2.5 |
| Example 4 | ZrCN | 0.5 | 52 | 2.1 | 2.5 |
| Example 5 | - | - | 51 | 2.1 | 2.0 |
| Example 6 | - | - | 50 | 2.0 | 2.0 |
| Example 7 | Zr_{0.95}Si_{0.05}CN | 0.5 | 51 | 2.2 | 4.5 |
| Example 8 | Zr_{0.95}V_{0.05}CN | 1 | 50 | 2.3 | 13.0 |
| Example 9 | ZrCN | 0.2 | 42 | 1.9 | 0.8 |
| Example 10 | - | - | 26 | 0.9 | 0.2 |
| Comparative Example 1 | - | - | 30 | 2.2 | 2.5 |
| Comparative Example 2 | - | - | 60 | 2.9 | 2.5 |
| Comparative Example 3 | - | - | 32 | 2.1 | 2.5 |
| Comparative Example 4 | - | - | 40 | 2.5 | 2.5 |
| Comparative Example 5 | - | - | 45 | 2.3 | 2.5 |

In the manner described above, the cutting tools of Examples 1 to 10 and Comparative Examples 1 to 5 were produced. It should be noted that the thickness of the surface layer is also included in the thickness of the whole of the coating film in Table 2.

The "Composition" of each of the first layer and the second layer in Table 1 and the "Composition" of the surface layer in Table 2 were measured using an XPS (X-ray photoelectron spectroscopy device).

The "Hardness" of the whole of the coating film in Table 2 was a value confirmed by a nano indenter (Nano Indenter XP provided by MTS).

The "Compressive Residual Stress" of the whole of the coating film in Table 2 is a value measured using an X-ray residual stress measurement device in accordance with a 2θ-sin²ψ method (see pages 54 to 66 of "X-ray stress measuring method" (Society of Materials Science, Japan, 1981, published by YOKENDO).

The "Crystallinity" of each of the first layer and the second layer in Table 1 was analyzed by an X-ray diffractometer.

### <Evaluation on Life of Cutting Tool>

### (Turning Test: Cutting Tests 1 to 3)

Each of the indexable cutting inserts each having a shape of CNMG120408 in Examples 1 to 10 and Comparative Examples 1 to 5 was subjected to wet continuous turning tests (cutting tests 1 and 3) and an intermittent turning test (cutting test 2) for an alloy steel (SCM440) and a nickel-based super alloy (Inconel (registered trademark) 718) under conditions shown in Table 3, so as to measure a time until a wear amount of a flank face of a cutting edge thereof became 0.2 mm. Results thereof are shown in Table 4. In Table 4, a longer cutting time represents a longer life. It should be noted that since Inconel (registered trademark) 718 includes only a minute amount of titanium, Inconel (registered trademark) 718 does not correspond to a "workpiece including titanium" in the present specification.

**[Table 3]**

| | Cutting Test 1 | Cutting Test 2 | Cutting Test 3 |
|---|---|---|---|
| | Continuous Cutting* (Turning) | Intermittent Cutting* (Turning) | Continuous Cutting* (Turning) |
| Workpiece | SCM440 (HB=300) | SCM440 (HB=300) | Inconel 718 (Aged Material: HB=400) |
| Cutting Speed (m/min) | 350 | 320 | 80 |
| Feed Rate (mm/rev) | 0.35 | 0.3 | 0.2 |
| Cut (mm) | 2.0 | 1.5 | 1.5 |
| Coolant | Water-Soluble | Water-Soluble | Water-Soluble |

| | | | |
|---|---|---|---|
| *Shape of insert: CNMG120408 | | | |

**[Table 4]**

| | Cutting Time (Minute) | | |
|---|---|---|---|
| | Cutting Test 1 Continuous Cutting (Turning) | Cutting Test 2 Intermittent Cutting (Turning) | Cutting Test 3 Continuous Cutting (Turning) |
| | SCM440 (HB=300) | SCM440 (HB=300) | Inconel 718 (Aged Material: HB=400) |
| Example 1 | 65 | 66 | 62 |
| Example 2 | 70 | 71 | 69 |
| Example 3 | 79 | 83 | 78 |
| Example 4 | 76 | 78 | 75 |
| Example 5 | 76 | 80 | 76 |
| Example 6 | 77 | 81 | 79 |
| Example 7 | 95 | 104 | 100 |
| Example 8 | 121 | 119 | 113 |
| Example 9 | 36 | 43 | 15 |
| Example 10 | 22 | 31 | 10 |
| Comparative Example 1 | 31 | 33 | 30 |
| Comparative Example 2 | 40 | 43 | 39 |
| Comparative Example 3 | 25 | 30 | 15 |
| Comparative Example 4 | 35 | 40 | 38 |
| Comparative Example 5 | 24 | 32 | 33 |

As compared with Examples 9 and 10 and Comparative Examples 1 to 5, in each of Examples 1 to 8, the wear amount of the flank face of the cutting edge was decreased greatly in each of the continuous turning tests and the intermittent turning test. It was confirmed that the life of the indexable cutting insert became significantly long even in the high-speed high-efficiency processing of the difficult-to-cut material.

### (Milling Test: Cutting Tests 4 and 5)

Each of the indexable cutting inserts each having a shape of SEMT13T3AGSN in Examples 1 to 10 and Comparative Examples 1 to 5 was subjected to surface milling under conditions of a dry milling test shown in Table 5 with the central line of a plate being aligned with the center of a cutter so as to measure a cutting length until the wear amount of the flank face of the cutting edge became 0.2 mm. The plate was composed of a difficult-to-cut material (SKD11 or FCD700) and had a width of 150 mm, and the cutter was wider than the plate to have φ160 mm. Results thereof are shown in Table 6. It should be noted that in Table 6, a longer cutting length represents a longer life.

**[Table 5]**

| | Cutting Test 4 | Cutting Test 5 | Cutting Test 6 |
|---|---|---|---|
| | Milling* | Milling* | End Milling* |
| Workpiece | SKD11 (HB=235) | FCD700 (HB=250) | Ti_{0.6}Al_{0.4}V Alloy (HB=310) |
| Cutting Speed (m/min) | 150 | 200 | 90 |
| Feed Rate (mm/t) | 0.15 | 0.2 | 0.05 |
| Axial Cut ap (mm) | 1.5 | 2.0 | 5.0 |
| Radial Cut ae (mm) | 150 | 150 | 1 |
| Coolant | Dry | Dry | Water-Soluble |

| | | | |
|---|---|---|---|
| *Shape of insert: SEMT13T3AGSN "Radius end mill with φ12mm | | | |

**[Table 6]**

| | Cutting Length (km) | | |
|---|---|---|---|
| | Cutting Test 4 Milling | Cutting Test 5 Milling | Cutting Test 6 End Milling |
| | SKD11 (HB=235) | FCD700 (HB=250) | Ti_{0.6}Al_{0.4}V Alloy (HB=310) |
| Example 1 | 2.7 | 2.5 | 2.3 |
| Example 2 | 2.9 | 2.7 | 2.4 |
| Example 3 | 3.8 | 3.6 | 2.8 |
| Example 4 | 3.1 | 3.3 | 2.6 |
| Example 5 | 2.9 | 3.1 | 2.5 |
| Example 6 | 2.9 | 3.0 | 2.4 |
| Example 7 | 4.1 | 4.2 | 2.0 |
| Example 8 | 6.2 | 5.5 | 1.6 |
| Example 9 | 1.3 | 1.1 | 1.9 |
| Example 10 | 1.1 | 1.0 | 1.5 |
| Comparative Example 1 | 1.5 | 1.8 | 0.7 |
| Comparative Example 2 | 1.6 | 1.9 | 0.9 |
| Comparative Example 3 | 1.0 | 1.5 | 0.5 |
| Comparative Example 4 | 1.3 | 1.9 | 0.4 |
| Comparative Example 5 | 1.2 | 1.8 | 0.6 |

As compared with Examples 9 and 10 and Comparative Examples 1 to 5, in each of Examples 1 to 8, the cutting length by the cutting edge is increased greatly. It was confirmed that the life of the indexable cutting insert became significantly long also in the high-speed and high-efficient milling of the difficult-to-cut material under the dry conditions.

### (End Milling Test: Cutting Test 6)

Each of the radius end mills of Examples 1 to 10 and Comparative Examples 1 to 5 each with φ12 mm was subjected to an wet end milling test under conditions shown in Table 5 so as to measure a cutting length until the wear amount of the flank face of the cutting edge became 0.2 mm. Results thereof are shown in Table 6. It should be noted that in Table 6, a longer cutting length represents a longer life.

As compared with Comparative Examples 1 to 5, in each of Examples 1 to 10, it was confirmed that the tool life became significantly long in the end milling process of the titanium alloy.

Heretofore, the embodiments and examples of the present invention have been illustrated, but it has been initially expected to appropriately combine the configurations of the embodiments and examples and modify them in various manners.

The embodiments and examples disclosed herein are illustrative and non-restrictive in any respect. The scope of the present invention is defined by the terms of the claims, rather than the embodiments and examples described above, and is intended to include any modifications within the scope and meaning equivalent to the terms of the claims.

### REFERENCE SIGNS LIST

1: cutting tool; 2: substrate; 3: coating film; 31: first layer; 32: second layer; 33: surface layer; 34: underlying layer; 35: intermediate layer; 120: film formation device; 121: rotation table; 122: substrate holder; 123: gas inlet; 124: gas outlet; 130: chamber; 131, 132, 133, 134: evaporation source; 141: pulse power supply; 142: bias power supply.

## Claims

1. A cutting tool comprising: a substrate; and a coating film formed on the substrate, wherein
the coating film includes a first layer formed on the substrate, and a second layer formed on the first layer,
the first layer is composed of a boride including titanium as a component element, and
the second layer is composed of a nitride including zirconium as a component element.

2. The cutting tool according to claim 1, wherein the first layer has a thickness of more than or equal to 0.5 µm and less than or equal to 10 µm.

3. The cutting tool according to claim 1 or claim 2, wherein the second layer has a thickness of more than or equal to 0.5 µm and less than or equal to 10 µm.

4. The cutting tool according to any one of claim 1 to claim 3, wherein the boride includes TiB₂.

5. The cutting tool according to any one of claim 1 to claim 4, wherein the nitride includes ZrN.

6. The cutting tool according to any one of claim 1 to claim 5, wherein
the boride further includes silicon as a component element, and
a ratio of a number of atoms of the silicon is more than 0 and less than or equal to 0.2 when a total number of metal atoms included in the boride is assumed to be 1.

7. The cutting tool according to any one of claim 1 to claim 6, wherein
the nitride further includes silicon as a component element, and
a ratio of a number of atoms of the silicon is more than 0 and less than or equal to 0.2 when a total number of metal atoms included in the nitride is assumed to be 1.

8. The cutting tool according to any one of claim 1 to claim 7, wherein
the boride further includes vanadium as a component element, and
a ratio of a number of atoms of the vanadium is more than 0 and less than or equal to 0.2 when a total number of metal atoms included in the boride is assumed to be 1.

9. The cutting tool according to any one of claim 1 to claim 8, wherein
the nitride further includes vanadium as a component element, and
a ratio of a number of atoms of the vanadium is more than 0 and less than or equal to 0.2 when a total number of metal atoms included in the nitride is assumed to be 1.

10. The cutting tool according to any one of claim 1 to claim 9, wherein
the coating film further includes a surface layer formed on the second layer, and
the surface layer is composed of a carbonitride including zirconium as a component element.

11. The cutting tool according to any one of claim 1 to claim 10, wherein
the coating film further includes an underlying layer formed between the substrate and the first layer, and
the underlying layer is composed of a metal or compound including, as a component element, at least one element selected from a group consisting of titanium and chromium.

12. A method for manufacturing the cutting tool recited in any one of claim 1 to claim 11, the method comprising:
preparing the substrate;
forming the first layer on the substrate using a physical vapor deposition method; and
forming the second layer on the first layer using the physical vapor deposition method.
